# EUROPEAN PATENT APPLICATION

(11) **EP 2 230 439 A2**
(43) Date of publication of application: **22.09.2010**
(21) Application number: 10002810.9
(22) Date of filing: 17.03.2010
(51) Int. Cl.: F21K 99/00, H01L 31/052, F21V 7/00, F21Y 101/02

(54) **Reflective light wavelength modulator**

(30) Priority: 20.03.2009 TW 98204465
(71) Applicant: ACPA Energy Conversion Devices Co., Ltd., Jhonghe City (Taipei County 23552) (TW)
(72) Inventor: Yao, Pei-Chih, Jhonghe City Taipei County 23552 (TW)
(74) Representative: Zeitler - Volpert - Kandlbinder

(57) **Abstract**

A reflective light wavelength modulator includes a reflection module 10,50 with a reflective arc surface 11, 51, at least one thermal conducting column 20 installed at the reflective arc surface 11,51, at least one optoelectric conversion module 30,70, particularly an illumination module, a solar cell or an photocell, installed on a distal surface of the thermal conducting column 20, and a reflective mask 40,80 installed at an appropriate distance from the optoelectric conversion module 30,70. The reflection module 10,50 or the reflective mask 40,80is made of a wavelength modulation material, such that when the light produced by the optoelectric conversion module 30,70 or the received light source is reflected from the reflective mask 40,80, the wavelength of the light source is changed to achieve the effects of providing a wavelength modulation function of a light source with a color and a cost-effective optoelectric equipment.

## Description

### BACKGROUND OF THE INVENTION

### 1. Field of the Invention

The present invention relates to an illumination or photoelectric conversion device, and more particularly to a reflective illumination or photoelectric conversion device capable of modulating a light source'swavelength..

### 2. Description of the Related Art

Light emitting diode (LED) comes with the advantages of a high efficiency, a power saving feature, a long life, a cool light without infrared spectrum property, a quick response, and a consistent color over other traditional light sources, and thus the light emitting diode (LED) is used extensively in illumination equipments, and it becomes an important subject for the development of optoelectronic and illumination industries. LED has replaced the applications of traditional light sources gradually, and present single-chip light emitting diodes (LED) emit white light by coating a phosphor onto the LED. For example, a yellow phosphor is coated onto a blue LED, or a RGB tri-band phosphor is added to an ultraviolet LED for producing white light. When the phosphor is excited by an excited beam that is emitted from the LED, an emitting beam is excited. In the meantime, when the remaining excited beam emitted from the LED but not absorbed by the phosphor is mixed with the beam excited by the phosphor, a white light is formed. The conventional LED emits light in a way with an insufficient flexibility of color modulation which constitutes a limitation to the popularity and application of the LED, and thus the design of the conventional LED is not good enough. Furthermore, the lifespan and the function of the LED are related to the heat dissipation efficiency, and thus the heat dissipation is a main issue of the development of present LEDs. The conventional low power LED emits light without using any peripheral application to provide a heat dissipation function, and thus this issue must be overcome in order to have a breakthrough in the high power LED industry.

Similarly, a related optoelectric conversion is used for improving the conversion efficiency and focusing a light source (such as solar energy) or using a wavelength modulation technique to improve the utility rate of sunlight, and overcoming the drawbacks of heat dissipating material and structure.

In view of the shortcomings of the application and the deficiency of the structural design of the conventional light emitting diode, and the illumination and focusing of a light source, the inventor of the present invention based on years of experience in the related industry to conduct extensive researches and experiments, and finally developed a practical and cost-effective reflective light wavelength modulator, in hope of enhancing the heat dissipating effect, providing a cost-effective and practical service to the general public, and promoting the development of the industry.

### SUMMARY OF THE INVENTION

Therefore, it is a primary objective of the present invention to provide a reflective light wavelength modulator applied in an illumination module using such as a light emitting diode (LED) as a light emitting source or a light source (such as solar energy) for an illumination to generate electric energy, and the reflective light wavelength modulator of the present invention provides a wavelength modulation function to the light source by means of the wavelength modulator operated together with simple peripherals, and the illumination module or photocell can be manufactured economically.

Another objective of the present invention is to provide a reflective light wavelength modulator that projects and reflects a light source to a wavelength modulation material to achieve the effects of modulating a light source color or improving an optoelectric conversion efficiency, while achieving an excellent heat dissipation.

To achieve the foregoing objective, the present invention provides a reflective light wavelength modulator comprising: a reflection module, made of a wavelength modulation material coated reflector, and having a reflective arc surface; at least one heat conducting column, installed at a position of the reflective arc surface of the reflection module; at least one optoelectric conversion module, particularly an illumination module, a solar cell or a photocell, installed onto a distal surface of the heat conducting column; a reflective mask, made of a wavelength modulation material, and installed with an appropriate distance from the optoelectric conversion module, such that the optoelectric conversion module can project a light onto the reflective mask or reflect a light source from the reflection module received by the photocell module to provide the effect of modulating the wavelength of the light source.

The present invention further comprises a plurality of optoelectric conversion modules, each being installed on a distal surface of each heat conducting column, wherein the heat conducting column is in a long bar shape.

The foregoing and other technical characteristics of the present invention will become apparent with the detailed description of the preferred embodiments and the illustration of the related drawings.

### BRIEF DESCRIPTION OF THE DRAWINGS

FIG. 1 is a perspective view of a first preferred embodiment of the present invention;
FIG. 2 is an exploded view of a first preferred embodiment of the present invention;
FIG. 3a is a cross-sectional view of an operating status of a first preferred embodiment of the present invention;
FIG. 3b is another cross-sectional view of an operating status of a first preferred embodiment of the present invention;
FIG. 4 is a perspective view of a second preferred embodiment of the present invention;
FIG. 5 is a cross-sectional view of an operating status of a second preferred embodiment of the present invention; and
FIG. 6 is a schematic view of a heat dissipating base of the present invention.

### DETAILED DESCRIPTION OF THE PREFERRED EMBODIMENTS

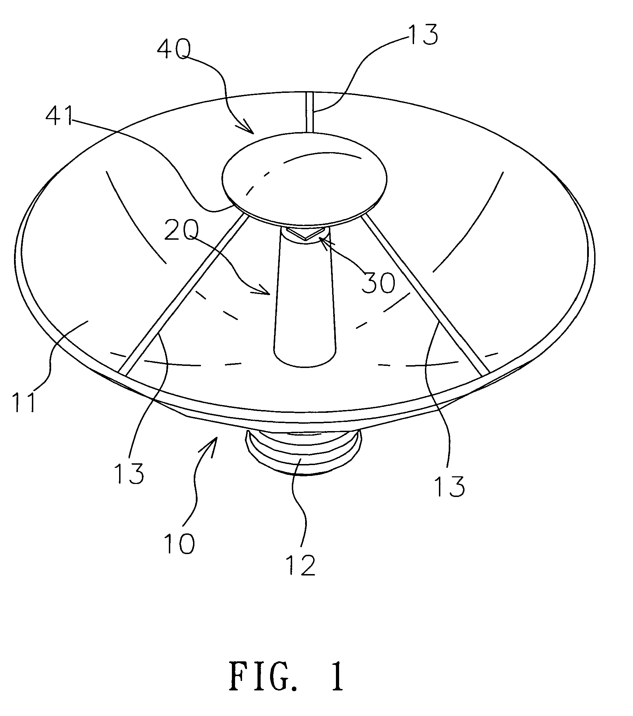

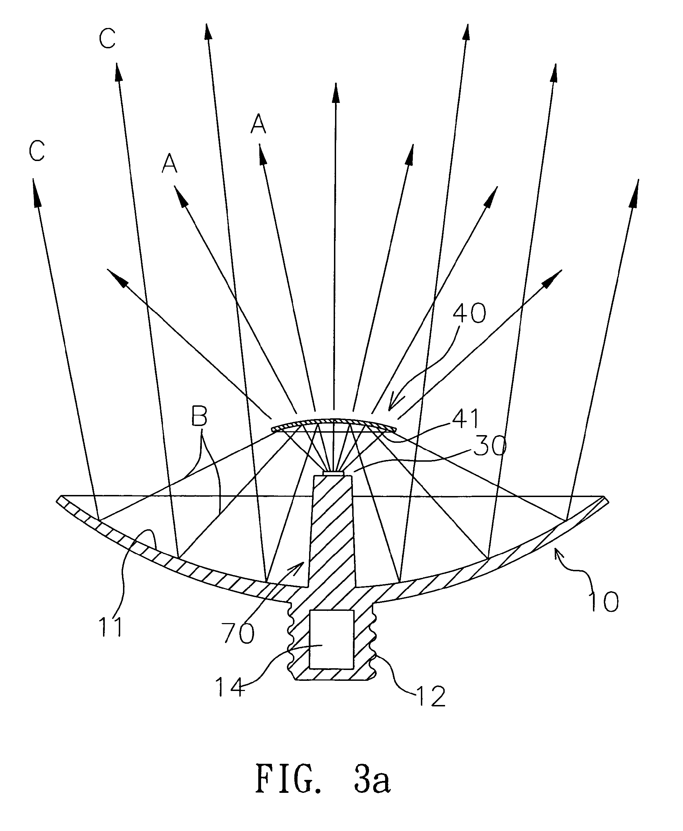

With reference to FIGS. 1, 2 and 3a for a reflective light wavelength modulator in accordance with a first preferred embodiment of the present invention, the reflective light wavelength modulator comprises a reflection module 10, a thermal conducting column 20, a optoelectric conversion module 30 and a reflective mask 40, wherein the reflection module 10 is made of a wavelength modulation material coated reflector, the coated material comosed of such as an organic polymer carrier added with an organic wavelength modulation material, a quantum dot luminescence color rendering modulation material and nanoparticle light intensity enhancer composite material, and the reflection module 10 of this preferred embodiment is a reflecting mirror, and the reflection module 10 includes an electric connector 12 installed under the reflective arc surface 11, and the reflection module 10 has a heat dissipation function, and the electric connector 12 is provided for connecting a power supply or inverter and includes a circuit board 14 as shown in FIG. 3a.

The thermal conducting column (or heat conducting column) 20 is substantially in a bar shape and installed at a central position of the reflective arc surface 11.

The conversion module 30 is an photocell (such as a solar cell) or a light source (such as light emitted diode) to generate light, and the conversion module 30 is installed on a distal surface of the thermal conducting column 20. In other words, the conversion module 30 is installed to the thermal conducting column 20 and disposed on a distal surface at another end of the reflection module 10, wherein the conversion module 30 is a light emitting diode (LED) package or laser diode (LD) package illumination element or photocell (such as a solar cell).

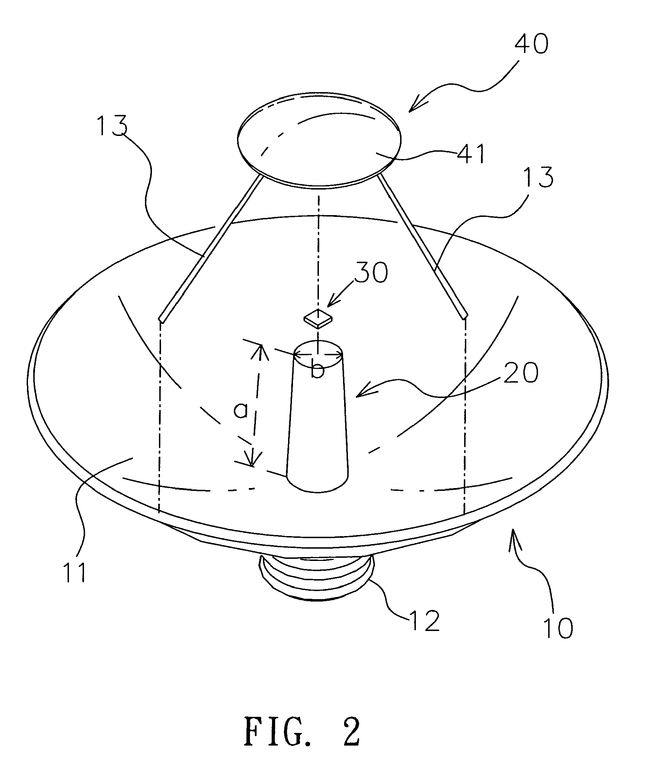

The reflective mask 40 is an opaque or semi-transparent reflecting mirror (wherein a light source is reflected or a portion of the light source is passed through the mask) and made of a wavelength modulation material such as an organic polymer carrier added with an organic wavelength modulation material, a quantum dot luminescence color rendering modulation material and a nanoparticle light intensity enhancer composite material, and the reflective mask 40 and the conversion module 30 are installed with an appropriate distance apart. In other words, the conversion module 30 is installed between the reflective mask 40 and the reflection module 10, such that the conversion module 30 can project a light source onto or receive a light source by the reflective mask 40 respectively. In a preferred embodiment, the reflective mask 40 is fixed at an appropriate position as shown in FIGS. 1 and 2, and a plurality of fixing elements 13 (or other fixing elements with different fixing methods) are coupled between the reflective mask 40 and the reflection module 10, and the fixing element 13 is a sheet support frame provided for fixing the reflective mask 40 (wherein the application of fixing elements 13 on the left side is an example showing one of the methods, but persons skilled in the art may use other methods to achieve the same effect). In addition, the reflective mask 40 has a projecting arc surface 41 disposed at a position opposite to the conversion module 30 (as shown in FIG. 3a).

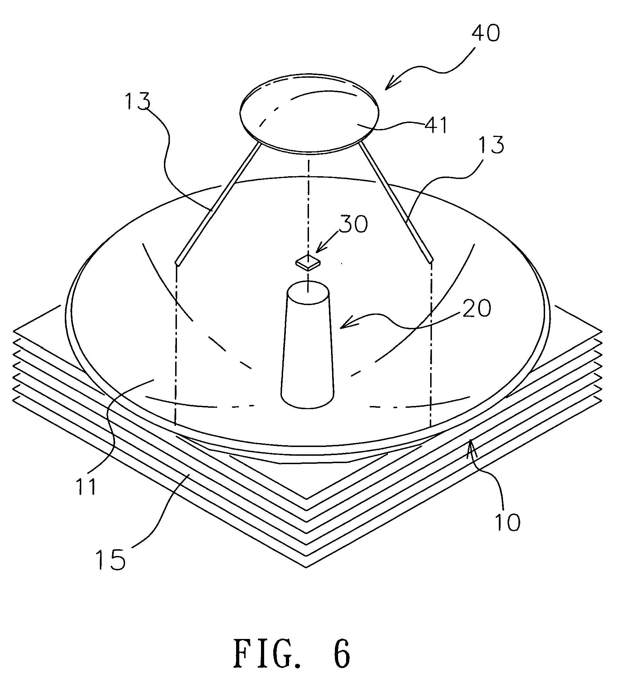

With reference to FIG. 3a for an application of the reflective light wavelength modulator in accordance with this preferred embodiment, if the conversion optoelectric module 30 is a light emitting diode (LED) package or laser diode (LD) package light emitting element, the light of the conversion module 30 is projected onto the reflective mask 40. Since the reflective mask 40 is a semi-transparent reflecting mirror, a portion of light A is passed through the reflective mask 40 and transmitted to the outside, and a portion of light B is reflected from the projecting arc surface 41 of the reflective mask 40, and the reflected light B is projected onto the reflective arc surface 11 of the reflection module 10 and a light C is reflected from the reflective arc surface 11, and the sum of the light A and the light C is equal to the total light projection intensity. Since the reflective mask 40 and the reflection module 10 both reflectors are coated with or made of a wavelength modulation material, a light projected onto the reflective mask 40 and reflected or passed through the reflection module 10 for a light reflection goes through a light source wavelength modulation, such that the light source color can be modulated. On the other hand, the heat generated by the optoelectric conversion module 30 can be conducted and dissipated from the thermal conducting column 20 to the reflection module 10, wherein the reflection module 10 is a metal based reflecting mirror with a heat dissipation function for dissipating the heat from the reflection module 10. Of course, a heat dissipating base 15 can be further installed at the bottom of the reflection module 10 as shown in FIG. 6 for providing an excellent heat dissipating effect.

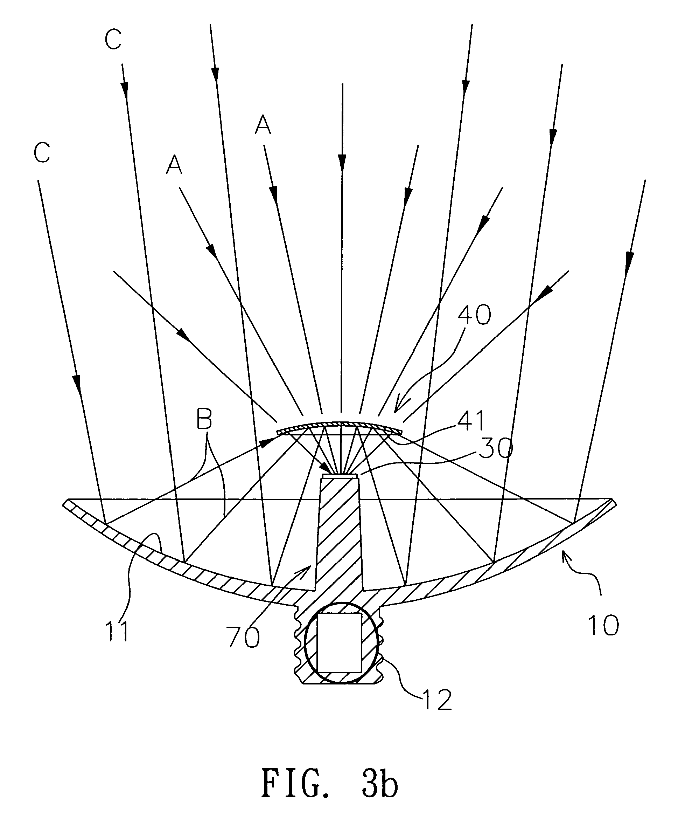

In FIG. 3b, if the conversion module 30 is an photoelectric conversion element (such as a solar cell), the sun light beam is projected onto the reflective mask 40. Since the reflective mask 40 is a semi-transparent reflecting mirror made of a wavelength modulation material, therefore a portion of light A is passed through the reflective mask 40 and then projected and focused at the conversion module 30 (such as the solar cell), and a portion of light C is projected onto the reflection module 10 and then reflected from the reflective arc surface 11 for a light reflection. The reflected light beam B is projected onto the reflective mask 40, reflected by the projecting arc surface 41, and focused at the conversion module 30. Since both the reflective mask 40 and the reflection module 10 are made of or coated with a wavelength modulation material, both of the light passed through the reflective mask 40 and reflected from the reflection module 10 go through a light source wavelength modulation, such that the conversion module 30 can have both a better sunlight energy conversion and focusing effect to increase the photoelectric conversion efficiency.

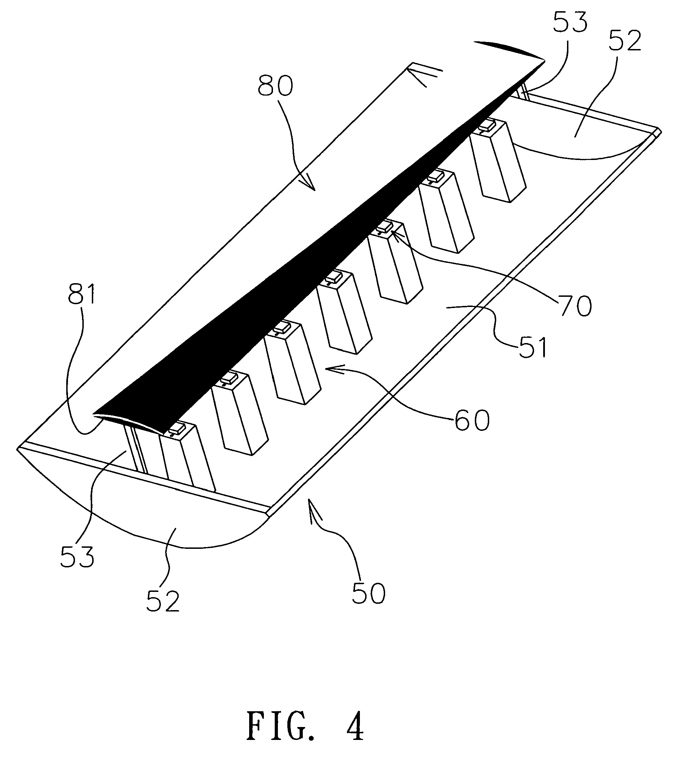

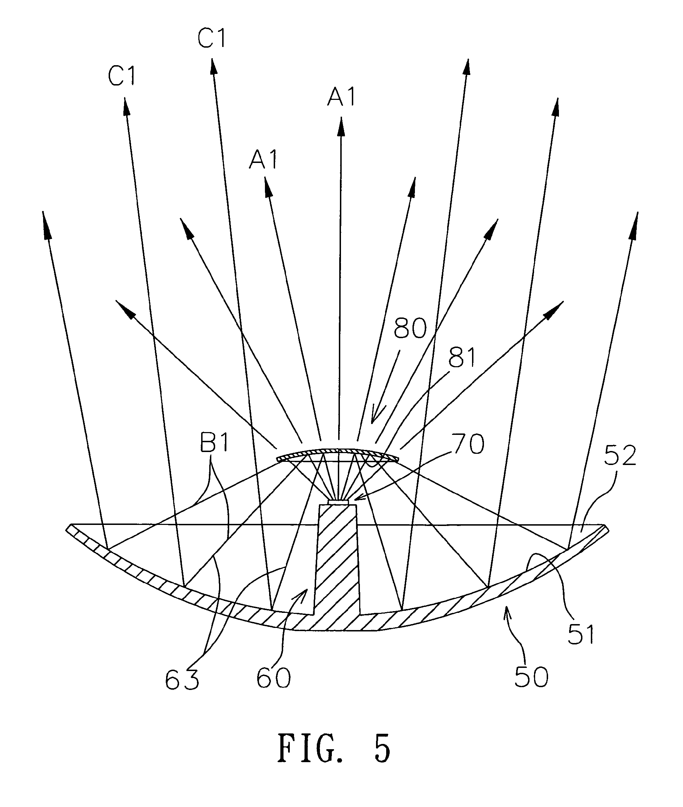

With reference to FIGS. 4 and 5 for a reflective light wavelength modulator in accordance with a second preferred embodiment of the present invention, the reflective light wavelength modulator comprises a reflection module 50, a plurality of thermal conducting columns 60, a plurality of optoelectric conversion modules 70 and a reflective mask 80, wherein the reflection module 50 is made of a wavelength modulation material coated reflector with such as an organic polymer carrier added with an organic wavelength modulation material, a quantum dot luminescence color rendering modulation material and a nanoparticle light intensity enhancer composite material, etc, and the reflection module 50 is substantially in a long-disc shape and includes a reflective arc surface 51 and two lateral end plates 52, and the reflection module 50 is a reflecting mirror having a heat dissipation function, and the plurality of thermal conducting columns 60 are installed on a reflective arc surface 51 of the reflection module 50, and the plurality of optoelectric conversion modules 70 are installed on a distal surface and corresponding to the plurality of the thermal conducting column 60 respectively. In other words, the optoelectric conversion module 70 is installed to the thermal conducting column 60 and opposite to a distal surface at another end of the reflection module 50, and the optoelectric conversion module 70 is a light emitting diode (LED) package or laser diode (LD) package light emitting element or photocell (solar cell). The reflective mask 80 is a semi-transparent reflecting mirror made of a wavelength modulation material such as an organic polymer carrier added with an organic wavelength modulation material, a quantum dot luminescence color rendering modulation material and a nanoparticle light intensity enhancer composite material. The reflective mask 80 and the conversion module 70 are installed with an appropriate distance apart. In other words, the conversion module 70 is installed between the reflective mask 80 and the reflection module 50, such that the light beam emitted from or received by the conversion module 70 is projected by the reflective mask 80 or reflected by the reflection module 50 and the reflective mask 80. In this preferred embodiment, the reflective mask 80 is fixed at an appropriate position as shown in FIG. 4, and both lateral sides of the reflective mask 80 are fixed onto the reflection module 50 by a fixing element 53 (such as a sheet support frame) or any other fixing element with a different fixing method), and the reflective mask 80 has a projecting arc surface 81 disposed opposite to the conversion module 70.

With reference to FIG. 5 for an application of the reflective light wavelength modulator of this preferred embodiment, if the conversion module 70 is a light emitting diode (LED) package or laser diode (LD) package light emitting element, the light source of the illumination module or the photocell is projected onto the reflective mask 80. Since the reflective mask 80 is a semi-transparent reflecting mirror, a portion of light A1 is passed through the reflective mask 80 and projected to the outside, and a portion of light B1 is reflected from the projecting arc surface 81 of the reflective mask 80, and the reflected light B1 is further projected onto the reflective arc surface 51 of the reflection module 50, and a light C1 is reflected from the reflective arc surface 51, and the sum of the light A1 and the light C1 is equal to the total light projection intensity. Since both the reflective mask 80 and the reflection module 50 are made of or coated with a wavelength modulation material, the light projected onto the reflective mask 80 and then reflected from or passed through the reflection module 50 goes through the light source wavelength modulation, such that the light source color can be modulated. On the other hand, the heat generated by the conversion module 70 can be conducted and dissipated from the thermal conducting column 60 to the reflection module 50, and the reflection module 50 is a metal based reflecting mirror having a heat dissipation function and capable of dissipating the heat from the conversion module 70.

Similarly, if the optoelectric conversion module 70 is an photoelectric conversion element such as a solar cell (same as the one as shown in the first preferred embodiment), the optoelectric conversion module 30 also has a better sunlight focusing effect to improve the optoelectric conversion efficiency.

In view of the description above, the present invention improves over the prior art and complies with patent application requirements, and thus is duly filed for patent application. While the invention has been described by device of specific embodiments, numerous modifications and variations could be made thereto by those generally skilled in the art without departing from the scope and spirit of the invention set forth in the claims.

## Claims

1. A reflective light wavelength modulator, comprising:
a reflection module 10, 50, made of a wavelength modulation material coated reflector, and having a reflective arc surface 11,51;
at least one heat conducting column 20, being in a bar shape, and
installed at a position of the reflective arc surface11,51 of the reflection module 10,50;
at least one optoelectric conversion module 30, 70, installed on a distal surface of the conducting column 20;
a reflective mask 40, 80, made of a wavelength modulation material,
and installed at a position corresponding to the conversion module 30, 70, for projecting a light beam to the reflective mask 40,80, or reflecting the light beam to an appropriate distance.

2. The reflective light wavelength modulator of claim 1, wherein the reflection module 10, 50 includes a metal based reflecting mirror having a heat dissipation function.

3. The reflective light wavelength modulator of claim 1, wherein the optoelectric conversion module 30, 70 is an illumination element and the illumination element is light emitting diode (LED) package or laser diode (LD) package.

4. The reflective light wavelength modulator of claim 1, wherein the optoelectric conversion module 30, 70 is a photoelectric conversion element, and the photoelectric conversion element is a solar cell or an photocell.

5. The reflective light wavelength modulator of claim 1, wherein the reflective mask 40,80 is fixed onto the reflection module 10,50 by a fixing element 13.

6. The reflective light wavelength modulator of claim 1, wherein the reflective mask 40, 80 includes a projecting arc surface 41, 81 corresponding to the optoelectric conversion module 30, 70.

7. The reflective light wavelength modulator of claim 6, wherein the light source emitted from the optoelectric conversion module 30, 70 is projected onto the reflective mask 40, 80 and a portion of the light source is passed through the reflective mask 40, 80 and projected to the outside, and another portion of the light source is reflected from the reflective mask 40, 80 to the reflection module 10, 50 and then reflected from the reflective arc surface 11, 51 to the outside.

8. The reflective light wavelength modulator of claim 6, wherein the portion of the light source received by the reflection module 10, 50 is projected to the reflective mask 40, 80 and part of light beam which received by the reflective mask 40, 80 is passed through the reflective mask 40, 80 and the rest part of light beam received by the reflective mask 40, 80 is reflected from the reflective mask and then projects to the optoelectric conversion module 30, 70.

9. The reflective light wavelength modulator of claim 1, wherein the reflection module 10, 50 includes a plurality of heat conducting columns 20, and each heat conducting column 20 includes a optoelectric conversion module 30, 70.

10. The reflective light wavelength modulator of claim 1, wherein the reflection module 10, 50 includes a heat dissipating base 15 disposed at the bottom of the reflection module 10, 50.
